**Europäisches Patentamt**

**European Patent Office**

**Office européen des brevets**

(19)

(11) Veröffentlichungsnummer: **0 031 874**
**B1**

(12) **EUROPÄISCHE PATENTSCHRIFT**

(45) Veröffentlichungstag der Patentschrift:
**19.09.84**

(21) Anmeldenummer: **80105891.8**

(22) Anmeldetag: **29.09.80**

(51) Int. Cl.³: **G 08 C 23/00**, G 08 C 19/24

(54) **Elektrische Installationseinrichtung.**

(30) Priorität: **22.12.79 DE 2951975**
**22.12.79 DE 2951976**

(43) Veröffentlichungstag der Anmeldung:
**15.07.81 Patentblatt 81/28**

(45) Bekanntmachung des Hinweises auf die Patenterteilung:
**19.09.84 Patentblatt 84/38**

(84) Benannte Vertragsstaaten:
**AT BE CH DE FR GB IT SE**

(56) Entgegenhaltungen:
**DE - A - 2 450 293**
**DE - A - 2 643 949**
**DE - A - 2 650 621**
**DE - A - 2 700 503**
**DE - B - 1 205 141**
**FR - A - 2 301 950**
**FR - A - 2 329 036**
**FR - A - 2 449 994**
**US - A - 3 534 351**
**US - A - 4 152 696**

**RADIO MENTOR ELECTRONIC, Band 43, Nr. 3, 1977, Seiten 096-097, Berlin, DE. H. EBERWEIN et al.: "Ferneinstellung von Lichtquellen" INFRAFERN - DAS BAUGRUPPENSYSTEM FÜR**

(73) Patentinhaber. **Voll, Walter, Ing. grad., Nikolaus-Fey-Strasse 2, D-8728 Hassfurt (DE)**

(72) Erfinder: **Voll, Walter, Ing. grad., Nikolaus-Fey-Strasse 2, D-8728 Hassfurt (DE)**

(74) Vertreter: **Gaiser, Hartmut, Dipl.-Ing., Sulzbacher Strasse 39, D-8500 Nürnberg 20 (DE)**

(56) Entgegenhaltungen: (Fortsetzung)
**INFRAROT-FERNBEDIENUNGEN, 6.1979, Siemens AG, Berlin und München, DE**
**ELECTRICAL DESIGN NEWS, Band 9, Heft 11, November 1964, Seiten 54,55 Denver, U.S.A. H. GREENE: "Complementary multivibrator"**
**ELECTRONIQUE INDUSTRIELLE; Heft 61, Februar 1963, Seiten 76-79 Paris, FR. C.D.: "Télémesure à terme unique"**
**ELO, Heft 12, Dezember 1979, Seiten 80-83, München, DE. L. FINDEISEN et al.: "Fern-Licht-Schalter"**

## Beschreibung

Die Erfindung betrifft eine elektrische Installationseinrichtung mit den Merkmalen im Oberbegriff des Anspruchs 1.

Bei der elektrischen Installation eines Raumes sind üblicherweise Beleuchtungskörper an der Decke oder an den Wänden des zu beleuchtenden Raumes angeordnet. Diese werden gewöhnlich durch Ein-Aus-Schalter geschaltet, die neben der Tür des Raumes angeordnet sind. Die Schalter liegen direkt im Stromkreis der Beleuchtungskörper. Dementsprechend müssen die elektrischen Leitungen verlegt werden. Dies ist mit einem beträchtlichen Installationsaufwand verbunden. Der Installationsaufwand steigt erheblich, wenn bei Raumumgestaltungen, beispielsweise bei der Altbausanierung, Schalter zu verlegen sind. Es müssen dann lange Schlitze in die Wände geschlagen werden, in welchen die Leitungen verlegt werden. Die Schlitze müssen danach wieder verputzt und die Wand muß gestrichen oder tapeziert werden. Ein hoher Installationsaufwand tritt auch dann auf, wenn eine vorgesehene Schaltung der Lampen geändert werden soll.

Zum Schalten eines Beleuchtungskörpers von mehreren Stellen aus werden Wechselschalter oder Kreuzschalter eingesetzt. Die Installation wird umso aufwendiger, von je mehr Stellen aus geschaltet werden soll. Um hier die Installation zu vereinfachen, werden Tastschalter verwendet, die einen Stromstoßschalter schalten, der in dem betreffenden Leitungszweig liegt.

In der DE-A-2 700 503 ist eine Installationseinrichtung beschrieben, die die Merkmale des Oberbegriffs des Anspruchs 1 im Prinzip zeigt. Mit einer solchen Installationseinrichtung ist der genannte Aufwand prinzipiell beträchtlich verringert. Um im Endergebnis den Aufwand zu verringern, müssen die Sender- und Empfängerschaltungen trotz der an sie gestellten Anforderungen einfach aufgebaut sein. Dabei treten Forderungen auf, mit denen sich die DE-A-2 700 503 nicht befaßt.

In der DE-A-2 450 293 ist eine Vorrichtung zur Fernbedienung von elektrischen Verbrauchsmitteln, beispielsweise der Hausinstallationstechnik beschrieben. Die dort gezeigte Schaltung ist durch die gewählte Kodierung bzw. Dekodierung der Schaltfunktionen aufwendig. Die Sendediode, strahlt auch bei nicht betätigtem Tastschalter. Bei betätigtem Tastschalter sind die Sendeimpulse ebenso lang wie die Impulspausen. Beides hat einen hohen Stromverbrauch des Senders zur Folge.

In der Literaturstelle Radiomentor Electronic, Band 43, Nr. 3, 1977, Seiten 096 bis 097, ist eine der DE-A-2 450 293 ähnliche Ferneinstellung von Lichtquellen im Prinzip beschrieben. Schaltungsvereinfachungen der DE-A-2 450 293 sind der Literaturstelle nicht zu entnehmen. Dort ist darauf hingewiesen, daß um die aufwendige Empfängerschaltung praxisgerecht unterbringen zu können, ein gerätespezifischer Schaltkreis entwikkelt werden mußte. Dies ist teuer.

In der US-A-3 534 351 ist eine Fernwirkeinrichtung beschrieben, bei der ein Sender ständig eine Lichtimpulsfolge in einen Raum abstrahlt. Der Empfänger spricht an, wenn die Übertragungsstrecke unterbrochen wird. Dementsprechend weist der Sender keinen manuell zu betätigenden Schalter auf. Vielmehr ist im Empfänger ein solcher Schalter vorgesehen, der jedoch bei einer Installationseinrichtung der eingangs genannten Art unbrauchbar ist. Der Sender ist an sich einfach aufgebaut. Die gegenüber den Sendeimpulsen langen Impulspausen sind lediglich im Hinblick auf einen möglichst niedrigen Stromverbrauch festgelegt. Im Empfänger ist ein monostabiler Multivibrator vorgesehen, der von jedem empfangenen Impuls angestoßen wird und während der Impulspause einen Kondensator auf einem so niedrigen Spannungswert hält, daß eine nachgeschaltete Schwingschaltung nicht anspricht. Der Kondensator lädt sich erst dann auf einen Wert, bei dem die Schwingschaltung anspricht, wenn Empfangsimpulse ausfallen. Die Dauer der Impulspause überträgt also keine Information. Vielmehr muß im Empfänger die für den Sender an sich vorteilhafte lange Impulspausendauer unterdrückt werden, um nicht ein Schalten der Schwingschaltung herbeizuführen.

Aufgabe der Erfindung ist es, eine Schaltung der eingangs genannten Art vorzuschlagen, bei der durch eine besondere Kodierung und Dekodierung zum Schalten mehrerer Leitungszweige ein schaltungstechnisch einfacher Aufbau mit geringem Strombedarf im Sender erreicht ist.

Erfindungsgemäß ist obige Aufgabe bei einer Installationseinrichtung der eingangs genannten Art durch die Merkmale im kennzeichnenden Teil des Anspruchs 1 gelöst.

Die Tastschaltereinheit ist nicht an das Netz angeschlossen. Sie erfordert keine Leitungsverlegung. Die Tastschaltereinheit läßt sich auf einfachste Weise dort anordnen, wo sie benötigt wird, beispielsweise neben der Tür des Raumes. Die Montage der Tastschaltereinheit an der Wand kann beispielsweise mittels einer Schraube oder mittels eines Doppelklebebandes vorgenommen werden.

Der Stromverbrauch der Tastschaltereinheit ist gering, da sie nur dann sendet, wenn der Taster betätigt ist.

Die Baueinheit mit dem Empfänger läßt sich einfach bei der betreffenden Wand- oder Deckenlampe, vorzugsweise in deren Sockel oder in einer Verteilerdose montieren. Die Baueinheit kann auch bei einer Steckdose montiert sein, die dann schaltbar ist.

Soll eine Lampe von verschiedenen Stellen aus geschaltet werden, dann sind an den Stellen Tastschaltereinheiten anzuordnen, die jeweils die gleiche Sendeimpulsfolge abgeben. Sollen von einer Tastschaltereinheit mehrere Lampen gleichzeitig geschaltet werden, dann sind Empfänger vorgesehen, die bei der gleichen Empfangsimpulsfolge ansprechen.

Erfahrungsgemäß genügt es, Sender und Empfänger vorzusehen, die auf vier bis fünf unterschiedliche Impulsfolgen ansprechen, da in Räumen selten mehr als vier bis fünf Lampen geschaltet werden sollen. Die Installationseinrichtungen nebeneinanderliegender Räume beeinflussen sich gegenseitig insbesondere dann nicht, wenn der Sender ein Infrarot-Sender ist.

Insgesamt brauchen bei dieser beschriebenen Installationseinrichtung bei einer Neuinstallation nur die zur Stromversorgung der Lampen oder Steckdosen notwendigen Leitungen verlegt zu werden. Die Tastschaltereinheiten lassen sich danach beliebig anbringen und den einzelnen Leitungszweigen zuordnen.

Von besonderem Vorteil ist bei der Erfindung, daß im Sender eine einfache Kodierung mittels der jeweils festgelegten Impulspausen möglich ist. Da die festgelegten Impulspausen gegenüber den Impulsen lang sind, ist der Stromverbrauch im Sender gering. Günstig ist weiterhin, daß durch die einfache Dekodierung der jeweiligen Impulspausendauer eine einfache Empfängerschaltung möglich ist. Dies hat zusätzlich den Vorteil, daß sich die Schaltung räumlich klein aufbauen läßt, ohne daß hierfür ein spezieller integrierter Schaltkreis geschaffen werden muß.

In bevorzugter Ausgestaltung der Erfindung ist jeder Sender so einstellbar, daß er wahlweise jede der Sendeimpulsfolgen abgeben kann, auf die die verschiedenen Empfänger ihre Leitungszweigschalter schalten. Außerdem ist vorzugsweise jeder Empfänger so einstellbar, daß er auf Empfangsimpulsfolgen wahlweise jeder der Impulspausen, die die Sender abstrahlen, seinen Leitungszweigschalter schalten kann. Es ist damit einerseits erreicht, daß alle Sender und Empfänger an sich gleich aufgebaut sind und der Anwender die gewünschte Zuordnung selbst einstellen oder ändern kann.

Vorzugsweise ist der Sender mit einer Infrarot-Sendediode und der Empfänger mit einer Infrarot-Empfangsdiode ausgestattet. Es läßt sich jedoch auch eine Niederfrequenz- oder Hochfrequenz-Übertragung vorsehen.

Weitere vorteilhafte Ausgestaltungen der Erfindung ergeben sich aus der folgenden Beschreibung von Ausführungsbeispielen. In der Zeichnung zeigt

Fig. 1 eine Wand eines Gebäuderaumes schematisch,

Fig. 2 eine Ansicht einer Tastschaltereinheit,

Fig. 3 die elektronische Schaltung der Tastschaltereinheit nach Fig. 2,

Fig. 4 die Schaltung einer Baueinheit mit Empfänger,

Fig. 5 Spannungsdiagramme einer Pegelauswertestufe nach Fig. 4,

Fig. 6 eine weitere Schaltung der Tastschaltereinheit nach Fig. 2 und

Fig. 7 eine Ergänzung der Empfängerschaltung nach Fig. 4 bei Verwendung der Schaltung nach Fig. 6.

In einer Wand 1 eines Raumes ist eine 220-V-Wechselstromleitung 2 mit den Polen R und Mp verlegt. Die Leitung 2 weist im Beispielsfalle drei Leitungszweige 3, 4 und 5 auf. Die Leitungszweige 3 und 4 zweigen an Verteilerdosen 6 und 7 ab. An die Leitungszweige 3 und 4 sind Glühbirnen 8 und 9 von Lampen angeschlossen. Der Leitungszweig 5 endet in einer Steckdose 10.

Vor die Lampen 8 und 9 und an die Steckdose 10 sind Baueinheiten 11, 12 und 13 geschaltet. Jede dieser Baueinheiten weist eine Infrarot-Empfangsdiode 14 auf.

In dem Raum sind an einer Wand, beispielsweise der Wand 1, drei Tastschaltereinheiten 15, 16 und 17 angebracht. Jede Tastschaltereinheit hat etwa die Grundabmessungen eines üblichen Raumlichtschalters. Die Verteilung der Tastschaltereinheiten in dem Raum ist beliebig.

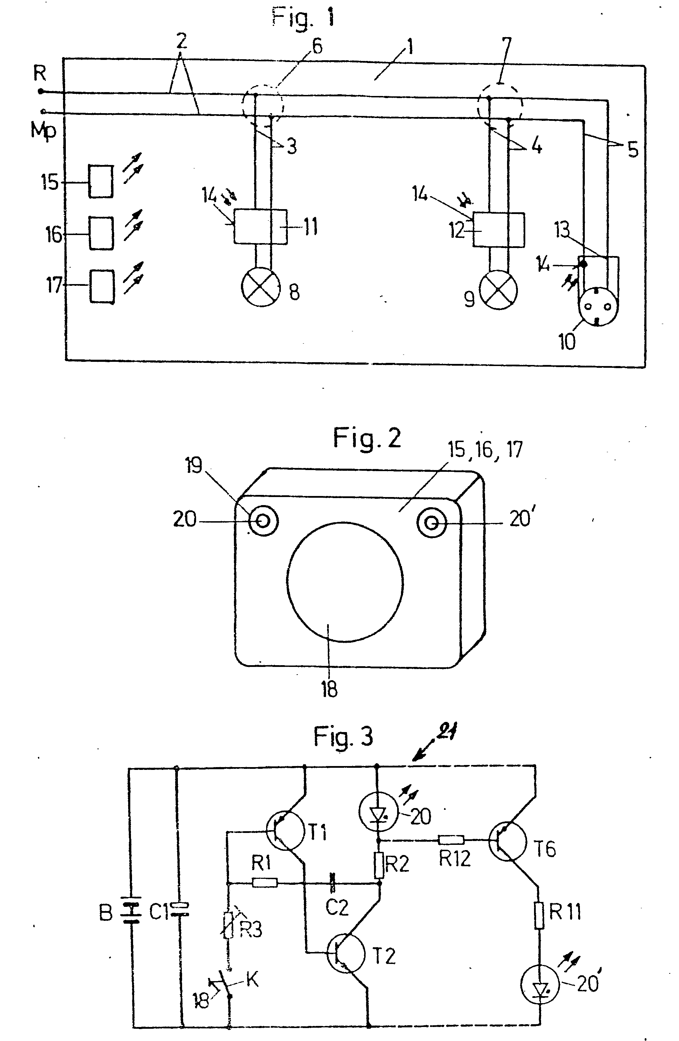

In Fig. 2 ist das Gehäuse einer Tastschaltereinheit 15, 16 oder 17 dargestellt. In der Mitte der Frontseite des Gehäuses ist eine großflächige Taste 18 angeordnet. Seitlich ist an der Tastschaltereinheit eine Öffnung 19 vorgesehen, durch die eine Infrarot-Diode 20 strahlt. Die Tastschaltereinheit kann beispielsweise mit einem Doppelklebeband oder einem Magneten an einer Wand befestigt sein. In der Tastschaltereinheit ist eine Batterie B untergebracht.

In Fig. 3 ist eine bevorzugte elektronische Schaltung der Tastschaltereinheit dargestellt. Parallel zur Batterie B ist ein Kondensator C1 geschaltet, der hohe Stromspitzen liefert. Parallel zur Batterie B liegt eine Sendeschaltung 21. Die Sendeschaltung 21 weist zwei komplementäre Transistoren T1 und T2 auf. An den Kollektor des Transistors T1 ist die Basis des Transistors T2 angeschlossen. Der Kollektor des Transistors T2 liegt über einen Rückkopplungszweig, bestehend aus einem Kondensator C2 und einem Widerstand R1 an der Basis des Transistors T1. An dem Kollektor des Transistors T2 liegt außerdem über einen Vorwiderstand R2 die Infrarot-Sendediode 20. An die Basis des Transistors T1 ist ein einstellbarer Widerstand R3 angeschlossen, zu dem ein von der Taste 18 betätigbarer Schaltkontakt K in Reihe liegt.

Sobald die Taste 18 betätigt und damit der Kontakt K geschlossen wird, fließt über den Widerstand R3 und die Basis des Transistors T1 ein Strom. Ein entsprechend dem Verstärkungsfaktor des Transistors T1 verstärkter Strom fließt dabei auf die Basis des Transistors T2. Der Transistor T2 schaltet. Über den Kondensator C2 und den Widerstand R1 erfolgt eine Rückkopplung auf die Basis des Transistors T1, so daß das Durchschalten schlagartig erfolgt. Gleichzeitig fließt ein hoher Strom, beispielsweise 2,5 A, über die Infrarot-Diode 20. Sobald der Kondensator C2 geladen ist, sperren die beiden Transistoren T1 und T2, wobei der Strom durch die Infrarot-Diode 20 endet. Die Infrarot-Diode 20 hat damit einen kurzen Infrarotimpuls abgestrahlt. Die Schaltung ist so ausgelegt, daß die Impulsdauer etwa 10 bis 50 μs beträgt.

Es ist davon auszugehen, daß die Betätigungszeit der Taste 18 wesentlich länger als die Impulsdauer ist. Es lädt sich damit der Kondensator C2 über die Widerstände R1 und R3 um. Die Dauer dieses Umladevorganges bestimmt die Impulspause zwischen zwei Sendeimpulsen. Die Impulspause beträgt beispielsweise 3 ms.

Günstig ist an der beschriebenen Sendeschaltung 21, daß sie mit einem Minimum an Bauelementen aufgebaut ist. Die Sendeschaltung übernimmt gleichzeitig die Impulserzeugung und die Verstärkung. Die Sendeschaltung weist einen äußerst geringen Stromverbrauch auf, so daß die Batterie B nur in sehr langen Zeitabständen ersetzt werden muß.

Der Widerstand R3 ist beispielsweise als Trimmwiderstand mit vier Raststellungen ausgebildet. Je nach der Einstellung des Trimmwiderstandes gibt die Sendeschaltung eine Infrarot-Impulsfolge mit kürzeren oder längeren Impulspausen ab. Es sind somit alle Tastschaltereinheiten 15, 16 und 17 gleich aufgebaut. Eine Zuordnung zu den einzelnen Empfängern der Baueinheiten 11, 12 und 13 erfolgt durch manuelle Umschaltung des Widerstands R3. Ersichtlich kann also die Tastschaltereinheit auch nachträglich umgeschaltet werden. Bei dem in Fig. 1 dargestellten Ausführungsbeispiel sind nur drei zu schaltende Leitungszweige vorgesehen. Es dient damit die vierte mögliche Einstellung des Widerstands R3 zur Reserve für eine spätere Installationserweiterung.

Anstelle der Sendeschaltung nach Fig. 3 können auch andere entsprechend wirkende Sendeschaltungen vorgesehen sein. Anstelle des Trimmwiderstandes R3 können auch vier Einzelwiderstände vorgesehen sein, die wahlweise wirksam geschaltet werden. Es kann auch jeder Sender als Widerstand R3 einen festen Widerstand aufweisen, wobei dann jeder Festwiderstand einen anderen Widerstandswert aufweist und bei einer etwaigen Umstellung der Sendeschaltung ausgetauscht wird. Die Einstellung der jeweils bestimmten Impulsfolge des Senders kann auch durch eine entsprechende Dimensionierung des Kondensators C2 vorgenommen werden. Anstelle der Infrarot-Diode 20 können auch Niederfrequenz- oder Hochfrequenz-Sendebauteile eingesetzt werden. Die Taste 18 braucht nicht mit einem mechanischen Kontakt K gekoppelt sein. Es kann auch eine an sich bekannte Sensortaste eingesetzt werden, die auf den Kontakt mit der Haut des Benutzers schaltet.

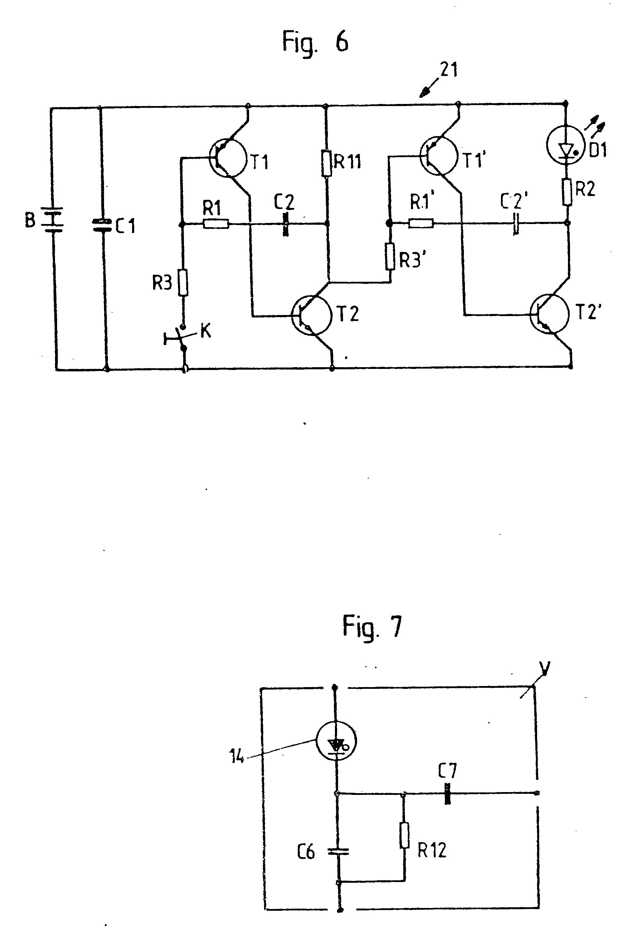

In Fig. 6 ist ein Sender dargestellt, der nicht einzelne Impulse entsprechend Fig. 5, sondern Impulspakete erzeugt. Im Prinzip ist hier die Schaltung nach Fig. 3 zweimal hintereinander geschaltet. Den Transistoren T1 und T2 entsprechen die Transistoren T1' und T2'. Dem RC-Glied R1 und C2 entspricht das RC-Glied R1' und C2'. Dem Widerstand R3 entspricht der Widerstand R3'. Zwischen dem Kollektor des Transistors T2 und der Batterie B ist ein Widerstand R11 vorgesehen. Die Dimensionierung der Zeitkonstanten des Lade- und Entladevorgangs des Kondensators C2' einerseits und des Kondensators C2 andererseits weicht voneinander ab. Die Dimensionierung des Kondensators C2, des Widerstands R1 und des Widerstands R3 ist nach den anhand der Fig. 3 beschriebenen Grundsätzen vorgenommen, also so, daß der Transistor T2 wesentlich länger sperrt als leitet. Solange der Transistor T2 durchgeschaltet ist, strahlt die Infrarot-Diode D1 ein Impulspaket ab. Es sind hierfür die von den Widerständen R1' und R3' und dem Kondensator C2' bestimmten Zeitkonstanten entsprechend kurz gewählt. Die Impulspakete können bei einer entsprechenden Dimensionierung des Widerstands R3' ein Tastverhältnis von etwa 1 annehmen. Damit treten anstelle jedes in Fig. 5a dargestellten Einzelimpulses zwischen den Impulspausen mehrere Impulse (Impulspaket) auf. Durch die Schaltung nach Fig. 6 ist es möglich, die Anzahl der Sendeimpulse zwischen den Impulspausen zu erhöhen.

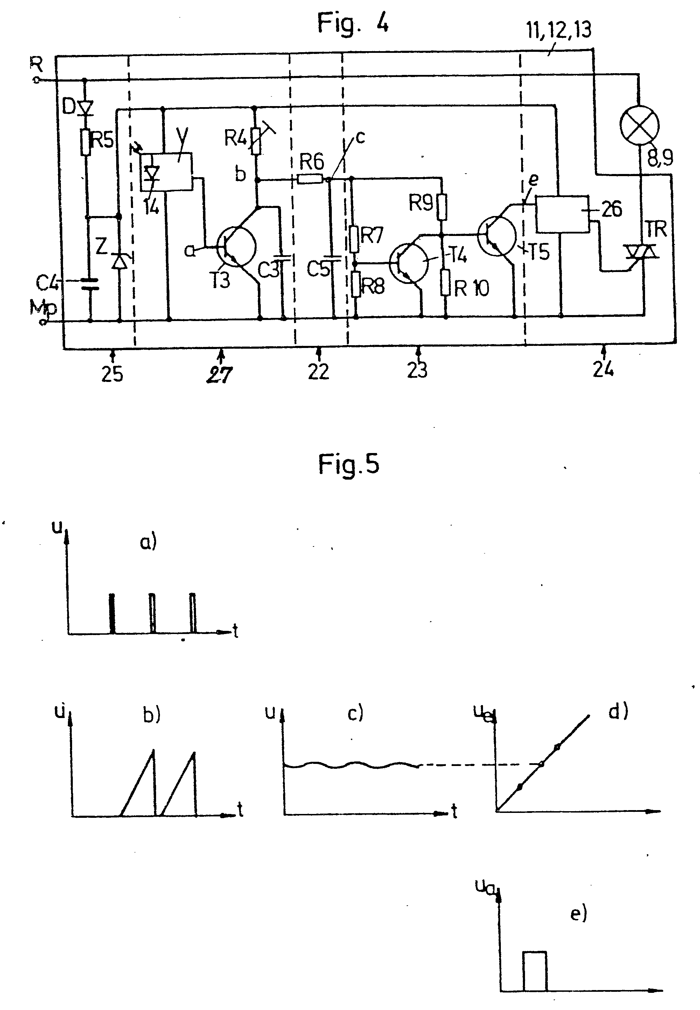

Den Infrarot-Empfangsdioden 14 im Eingangsteil 27 der Baueinheiten 11, 12 und 13 ist jeweils ein Vorverstärker V nachgeschaltet (vgl. Fig. 4). Der Ausgang des Verstärkers V ist an die Basis eines Schalttransistors T3 angeschlossen, dessen Kollektor-Emitter-Strecke parallel zu einem Kondensator C3 eines RC-Ladekreises mit einem Ladewiderstand R4 liegt. Dem Ladekreis ist eine Siebstufe 22 nachgeschaltet, an deren Ausgang eine Spannungspegel-Auswertestufe 23 liegt. Der Ausgang der Spannungspegel-Auswertestufe 23 schaltet einen Stromstoßschalter 24. Zur Spannungsversorgung ist eine Gleichrichterstufe 25 zwischen den Netzpolen R und Mp vorgesehen.

Die Gleichrichterstufe 25 weist in Reihe liegend eine Gleichrichterdiode D, einen Widerstand R5 und einen Kondensator C4 auf. Parallel zum Kondensator C4 liegt eine Zenerdiode Z zur Spannungsstabilisierung. Parallel zur Zenerdiode Z liegt der Vorverstärker V, der Ladekreis R4, C3 und eine Ansteuerschaltung 26 für ein Triac TR des Stromstoßschalters 24. Der Triac TR ist der Lampe 8 bzw. 9 bzw. der Steckdose 10 vorgeschaltet.

Der Kondensator C3 lädt sich über den Widerstand R4 auf. Sobald an der Basis des Transistors T3 ein Empfangsimpuls (vgl. Fig. 5a) auftritt, wird der Kondensator C3 schlagartig entladen. In der Impulspause bis zum nächsten Empfangsimpuls lädt sich der Kondensator C3 wieder auf. Der Widerstand R4 und der Kondensator C3 sind so bemessen, daß dabei eine Sägezahnspannung entsteht (vgl. Fig. 5b). Die Sägezahnspannung wird in der Siebstufe 22, die aus einem Widerstand R6 und einem Kondensator C5 besteht, gesiebt. Am Ausgang der Siebstufe 22 steht damit ein Gleichspannungspegel an, der von den Impulspausen der Empfangsimpulsfolge abhängig ist. Bei Impulsfolgen mit längeren Impulspausen ist dieser Spannungspegel höher als bei Impulsfolgen mit kürzeren Impulspausen. Da die Baueinheiten 11, 12 und 13 ihren Stromstoßschalter 24 nur bei einer bestimmten Empfangsimpulsfolge schalten sollen, wird in der Spannungspegel-Auswertestufe 23 ausgewertet, ob ein bestimmter Spannungspegel vorliegt. Die Auswertestufe 23 ist hierfür als an sich bekannter Fensterdiskriminator ausgelegt. Es sind hierbei zwei Spannungsteiler R7, R8 bzw. R9, R10 vorgesehen. Am Abgriff jedes der Spannungsteiler liegt die Basis eines Transistors T4 bzw. T5. Der Kollektor des Transistors T4 ist an die Basis des Transistors T5 angeschlossen. Der Kollektor des Transistors T5 bildet den Schaltungsausgang, der an die Ansteuerschaltung 26 angeschlossen ist. In Fig. 5d ist die Kennlinie der Spannungspegel-Auswertestufe 23 gezeigt. Bei einem bestimmten Spannungswert am Eingang (vgl. Fig. 5c) der Auswertestufe 23 schaltet diese durch. Steigt die Eingangsspannung, dann schaltet die Auswertestufe 23 ab. Durch die Auslegung der Widerstände R7 bis R10 in den einzelnen Baueinheiten 11, 12 und 13 läßt sich erreichen, daß jede Baueinheit ihren Stromstoßschalter bei einem anderen Spannungspegel (vgl. Fig. 5c) schaltet. Es ist damit erreicht, daß die Baueinheiten 11, 12 und 13 nur bei Empfangsimpulsen schalten, für die sie ausgelegt sind.

Die Einstellung der Baueinheiten 11, 12 und 13 auf eine bestimmte Impulsfolge läßt sich auch dadurch erreichen, daß der Ladewiderstand R4 in den Baueinheiten unterschiedlich ausgelegt wird. Der Widerstand R4 kann hierfür auch als Trimmwiderstand ausgebildet sein. Durch die Einstellung des Ladewiderstands R4 wird der Anstieg der Sägezahnspannung verändert. In diesem Fall können die Spannungspegel-Auswertestufen 23 aller Baueinheiten gleich aufgebaut sein.

Durch die Einstellbarkeit des Anstiegs der Sägezahnspannung ist erreicht, daß eine Impulsfolge mit bestimmten Impulspausen in den unterschiedlichen Baueinheiten zu unterschiedlichen Spannungspegeln (vgl. Fig. 5c) führt.

Die Ansteuerschaltung 26 für den Triac TR enthält ein nicht näher dargestelltes Flip-Flop, das den Triac TR bei aufeinanderfolgenden Schaltimpulsen (vgl. Fig. 5e) abwechselnd ein- und ausschaltet. Anstelle des beschriebenen Stromstoßschalters können auch andere Stromstoßschalter, wie beispielsweise ein Stromstoßrelais, eingesetzt werden. Es lassen sich auch als Stromstoßschalter marktbekannte Digital-Dimmer einsetzen. Diese schalten wie Stromstoßschalter ein und aus. Zusätzlich dimmen sie die Helligkeit der Lampen 8, 9 in Abhängigkeit von der Zeitdauer, mit der die Taste 18 betätigt wird. Die Länge des Schaltimpulses am Kollektor des Transistors T5 (vgl. Fig. 5e) hängt davon ab, wie lange die Taste 18 betätigt wird, wie lange also die Sendeimpulsfolge abgestrahlt wird.

In Fig. 7 ist ein Verstärker V für die Baueinheiten 11, 12, 13 gezeigt, der dann verwendet wird, wenn die Sendeschaltung 21 entsprechend Fig. 6 aufgebaut ist. Der Empfangsdiode 14 ist ein Filter aus einem Kondensator C6 und einem Widerstand R12 nachgeschaltet. Mit einem Koppelkondensator C7 ist die Empfangsdiode 14 an den Transistor T3 angeschlossen. Das Filter C6, R12 ist auf die Frequenz der Impulspakete der Sendeschaltung 21 (vgl. Fig. 6) abgestimmt. Ein Verstärker V, dessen Filter auf eine andere Frequenz als die des Impulspaketes eines Senders eingestellt ist, kann also auf diesen nicht ansprechen. Es ist damit möglich, in räumlicher Nähe zwei oder mehr Gruppen von Tastschaltereinheiten 15, 16, 17 entsprechenden Gruppen von Baueinheiten 11, 12, 13 zuzuordnen, wobei die Filterfrequenzen der Baueinheiten entsprechend auf die Impulspaketfrequenzen der Tastschaltereinheiten abgestimmt sind. Dies empfiehlt sich z. B. bei sehr großen Räumen oder gegeneinander offenen Räumen mit vielen zu schaltenden Verbrauchern. Außerdem ist durch das Senden von Impulspaketen und deren Filterung eine verbesserte Störunempfindlichkeit und eine größere Reichweite möglich.

Die beschriebene Installationseinrichtung eignet sich für eine Serienfertigung, da die Baueinheiten einerseits und die Tastschaltereinheiten andererseits gleich aufgebaut sein können. Die Anpassung an die jeweiligen Installationswünsche kann bei der Montage erfolgen. Es brauchen hierfür nur die Widerstände R3 und R4 entsprechend eingestellt werden. Die Baueinheiten können den Tastschaltereinheiten beliebig zugeordnet werden. Die Einstellung kann auch so erfolgen, daß von einer Tastschaltereinheit zwei oder mehr Baueinheiten gleichzeitig geschaltet werden. Die Einstellung kann auch so erfolgen, daß eine oder mehrere Baueinheiten von mehreren Tastschaltereinheiten, die dann an unterschiedlichen Stellen des Raums angebracht sind, geschaltet werden können.

Selbstverständlich können auch mehr als vier Einstellmöglichkeiten, insbesondere der Widerstände R3 und R4, vorgesehen sein. Gewöhnlich werden vier bis fünf Einstellmöglichkeiten für einen Raum genügen. In danebenliegenden Räumen kann mit den gleichen Einstellmöglichkeiten gearbeitet werden, da die Tastschaltereinheiten nicht auf Baueinheiten anderer Räume wirken.

Durch die Baueinheit 13 ist es möglich, auch an Steckdosen angeschlossene Tischlampen oder andere elektrische Verbraucher von der Eingangstür des Raumes aus zu schalten. Die Baueinheit 13 kann so aufgebaut werden, daß sie selbst in die Steckdose 10 einsteckbar ist und ihrerseits eine Steckdose aufweist, in die ein Verbindungskabel einzustecken ist. Die Baueinheit 13 ist damit so aufgebaut, wie dies von Zeitschaltuhren bekannt ist.

Ist eine magnetische Halterung der Tastschaltereinheiten 15, 16 und 17 beispielsweise in der Weise vorgesehen, daß an der Wand Metallplättchen befestigt und in den Tastschaltereinheiten Magnete angeordnet sind, dann lassen sich die Tastschaltereinheiten einfach abnehmen und von einer anderen Stelle des Raumes aus bedienen.

Zur Verbreiterung der Sendebasis und Erhöhung der Sendeleistung können die Tastschaltereinheiten 15, 16 und 17 eine weitere Infrarot-Diode 20' aufweisen, die an einer der Diode 20 gegenüberliegenden Stelle an der Tastschaltereinheit angeordnet ist. Es ist damit die Gefahr verringert, daß beide Sendedioden bei der Betätigung der Taste 18 von der Hand direkt abgedeckt werden.

Die Sendediode 20' kann in Reihe oder parallel zur Sendediode 20 geschaltet sein. Die Sendediode 20' kann auch mit einem Widerstand R11 in Reihe zur Emitter-Kollektor-Strecke eines weiteren Transistors T6 geschaltet sein, dessen Basis über einen Widerstand R12 an die Sendediode 20 angeschlossen ist. Dies ist in Fig. 3 dargestellt. In diesem Fall verlangt die Sendediode 20' keine Erhöhung der Spannung der Batterie B und auch keine Vergrößerung der Leistung des Transistors T2.

## Patentansprüche

1. Elektrische Installationseinrichtung für einen Raum eines Gebäudes zum unabhängigen Schalten mehrerer Leitungszweige (3, 4, 5) des elektrischen Netzes (R, Mp), an die Verbraucher (8, 9, 10), insbesondere Lampen, angeschlossen oder anschließbar sind, mittels Tastschaltereinheiten (15, 16, 17), wofür eine Kodierung vorgesehen und wobei an zu schaltende Leitungszweige (3, 4, 5) eine Baueinheit (11, 12, 13) angeschlossen ist, die einen Leitungszweigschalter (24) für einen zu schaltenden Leitungszweig und einen bei einem Empfangssignal den Leitungsschalter schaltenden Empfänger (27, 22, 23) umfaßt, und die Tastschaltereinheit (15, 16, 17) eine netzunabhängige Stromversorgungsquelle (B) und einen Sender (21) aufweist, der bei Betätigung des Tastschalters (18) ein Sendesignal bestimmter Frequenz netzunabhängig abstrahlt, auf das derjenige Leitungszweigschalter (24) schaltet, dessen Empfänger (27, 22, 23) auf diese Frequenz ausgelegt ist, dadurch gekennzeichnet, daß jeder Sender (21) als Sendesignal eine Folge von informationsunabhängig kurzen Impulsen mit festgelegten Impulspausen, deren Dauer jeweils einem bestimmten Leitungszweig (3 bzw. 4 bzw. 5) zugeordnet ist, abstrahlt, daß in jedem Empfänger (27, 22, 23) eine Schaltung (R4, C3) vorgesehen ist, die eine Sägezahnspannung (Fig. 5b) erzeugt, deren Periode den Impulspausen der Empfangsimpulsfolge (Fig. 5a) entsprechen und deren Amplitude demzufolge der Impulspausendauer entspricht, wobei diese Amplitude als Schaltkriterium für den betreffenden Leitungszweigschalter mittels einer weiteren Schaltung (22, 23) des Empfängers ausgewertet wird, und daß jeder Leitungszweigschalter (24) eines Leitungszweiges (3, 4, 5) nur auf eine Empfangsimpulsfolge mit der diesem Leitungszweig (3 bzw. 4 bzw. 5) zugeordneten Impulspausendauer anspricht, die der der gerade gesendeten Impulsfolge entspricht.

2. Installationseinrichtung nach Anspruch 1, dadurch gekennzeichnet, daß jeder Sender (21) so einstellbar ist, daß er Sendeimpulsfolgen mit wahlweise jeder der Impulspausen abgeben kann, auf die die verschiedenen Empfänger (27, 22, 23) ihre Leitungszweigschalter (24) schalten.

3. Installationseinrichtung nach Anspruch 1 oder 2, dadurch gekennzeichnet, daß jeder Empfänger (27, 22, 23) so einstellbar ist, daß er auf Empfangsimpulsfolgen wahlweise jeder der Impulspausen, die die Sender (21) abstrahlen, seinen Leitungszweigschalter (24) schalten kann.

4. Installationseinrichtung nach Anspruch 2 oder 3, dadurch gekennzeichnet, daß jede Tastschaltereinheit (15, 16, 17) und/oder jede Baueinheit (11, 12, 13) einen Trimmwiderstand (R3 bzw. R4) mit Raststellungen aufweist.

5. Installationseinrichtung nach einem der vorhergehenden Ansprüche, dadurch gekennzeichnet, daß jede Tastschaltereinheit (15, 16, 17) eine Infrarot-Sendediode (20, 20', D1) und jede Baueinheit (11, 12, 13) eine Infrarot-Empfangsdiode (14) aufweist.

6. Installationseinrichtung nach einem der vorhergehenden Ansprüche, bei der die Tastschaltereinheit eine großflächige Taste aufweist, dadurch gekennzeichnet, daß mittels der Taste (18) ein Kontakt (K) der Sendeschaltung (21) schließbar ist, der über einen Widerstand (R3) mit der Basis eines ersten Transistors (T1) verbunden ist, daß der Kollektor des ersten Transistors (T1) an die Basis eines komplementären Transistors (T2) angeschlossen ist, in dessen Kollektorkreis die Sendediode (20) liegt und dessen Kollektor über einen Rückkopplungszweig (C2, R1) mit der Basis des ersten Transistors (T1) verbunden ist, und daß die Tastschaltereinheit (15, 16, 17) zur Stromversorgung eine Batterie (B) und einen dieser parallelgeschalteten Kondensator (C1) aufweist.

7. Installationseinrichtung nach einem der vorhergehenden Ansprüche, dadurch gekennzeichnet, daß in jeder Baueinheit (11, 12, 13) ein über eine Gleichrichterstufe (25) aus dem Netz (R, Mp) aufladbarer RC-Ladekreis (R4, C3) vorgesehen ist, dessen Kondensator (C3) beim Auftreten eines Empfangsimpulses entladen wird, wobei die Sägezahnspannung entsteht, die in einer Siebstufe (22) gesiebt und von einem Fensterdiskriminator (23) ausgewertet wird.

8. Installationseinrichtung nach einem der vorhergehenden Ansprüche, dadurch gekennzeichnet, daß jeder Sendeimpuls der Tastschaltereinheit (15, 16, 17) von einem Impulspaket gebildet ist und in der Baueinheit (11, 12, 13) ein Filter (C6, R12) vorgesehen ist, welches auf die Frequenz des Impulspaketes der zugeordneten Tastschaltereinheit abgestimmt ist.

9. Installationseinrichtung nach einem der vorhergehenden Ansprüche, dadurch gekennzeichnet, daß der Empfänger (27, 22, 23) und gegebenenfalls eine Ansteuerschaltung (26) des Leitungszweigschalters (24) über eine Gleichrichterstufe (25) aus dem Netz (R, Mp) gespeist sind.

## Claims

1. Electrical installation device for a room of a building for the independent switching of a plurality of line branches (3, 4, 5) of the electrical network (R, Mp), to which consumer units (8, 9, 10), especially lamps, are or can be connected, by means of momentary contact switch units (15, 16, 17), for which purpose a coding is provided and wherein a component (11, 12, 13) is connected to line branches (3, 4, 5) to be switched, which component comprises a line branch switch (24) for a line branch to be switched and a receiver (27, 22, 23) which switches the line switch when a reception signal occurs, and the momentary contact switch unit (15, 16, 17) comprises a network-independent electricity supply (B) and a transmitter (21) which, when the momentary contact switch (18) is actuated, emits a transmission signal of specific frequency independently of the network, to which that line branch switch (24), of which the receiver (27, 22, 23) is designed for this frequency, switches, characterized in that each transmitter (21) emits, as transmission signal, a sequence of information-independent, short pulses with predetermined pulse pauses, the duration of each of which is associated with a specific line branch (3 or 4 or 5 respectively), that in each receiver (27, 22, 23) a circuit (R4, C3) is provided, which generates a sawtooth voltage (fig. 5b), the periods of which correspond to the pulse pauses of the reception pulse sequence (5a) and the amplitude of which consequently corresponds to the pulse pause duration, this amplitude being evaluated as switching criterion for the relevant line branch switch by means of a further circuit (22, 23) of the receiver, and that each line branch switch (24) of a line branch (3, 4, 5) responds to only one reception pulse sequence having the pulse pause duration associated with this line branch (3 or 4 or 5 respectively), which corresponds to the pause duration of the pulse sequence just transmitted.

2. Installation device according to claim 1, characterized in that each transmitter (21) is so adjustable that it can emit transmission pulse sequences with any of the pulse pauses, as desired, to which the different receivers (27, 22, 23) switch their line branch switches (24).

3. Installation device according to claim 1 or 2, characterized in that each receiver (27, 22, 23) is so adjustable that it can switch its line branch switch (24) to reception pulse sequences, as desired, of any of the pulse pauses which the transmitters (21) transmit.

4. Installation device according to claim 2 or 3, characterized in that each momentary contact switch unit (15, 16, 17) and/or each component (11, 12, 13) comprises a trim resistor (R3, R4 respectively) possessing dwell positions.

5. Installation device according to one of the preceding claims, characterized in that each momentary contact switch unit (15, 16, 17) comprises an infrared transmission diode (20, 20', D1) and each component (11, 12, 13) comprises an infrared reception diode (14).

6. Installation device according to one of the preceding claims, wherein the momentary contact switch unit possesses a large-area key, characterized in that, by means of the key (18), a contact (K) of the transmission circuit (21) can be closed, which contact is connected via a resistor (R3) with the base of a first transistor (T1), that the collector of the first transistor (T1) is connected to the base of a complementary transistor (T2), in the collector circuit of which the transmission diode (20) is situated and the collector of which is connected via a feedback coupling branch (C2, R1) with the base of the first transistor (T1), and that the momentary contact switch unit (15, 16, 17) possesses a battery (B) for the electricity supply and a capacitor (C1) connected in parallel with this battery.

7. Installation device according to one of the preceding claims, characterized in that, in each component (11, 12, 13), a RC charging circuit (R4, C3), which can be charged via a rectifier stage (25) from the supply network (R, Mp), is provided, the capacitor (C3) of which is discharged when a reception pulse occurs, the sawtooth voltage being produced, which is filtered in a filter stage (22) and is evaluated by a window discriminator (23).

8. Installation device according to one of the preceding claims, characterized in that each transmission pulse of the momentary contact switch unit (15, 16, 17) is formed of a pulse package and that a filter (C6, R12) is provided in the component (11, 12, 13), which filter is tuned to the frequency of the pulse package of the associated momentary contact switch unit.

9. Installation device according to one of the preceding claims, characterized in that the receiver (27, 22, 23) and, possibly also, a governing circuit (26) of the line branch switch (24) is supplied via a rectifier stage (25) from the supply network (R, Mp).

## Revendications

1. Installation électrique pour local de bâtiment, pour la commande indépendante de plusieurs branches de ligne (3, 4, 5) du réseau électrique (R, Mp), auxquelles des consommateurs (8, 9, 10), en particulier des lampes, sont reliées ou peuvent être reliées, au moyen d'unités d'interrupteur à une position (15, 16, 17), un codage étant prévu à cet effet, tandis qu'aux branches de ligne (3, 4, 5) à commander est relié un bloc (11, 12, 13) qui comprend un interrupteur de branche de ligne (24) pour une branche de ligne à commander et un récepteur (27, 22, 23) qui manoeuvre l'interrupteur de ligne lors d'un signal de réception, l'unité d'interrupteur à une position (15, 16, 17) présentant une source d'alimentation électrique (B) indépendante du réseau et un émetteur (21) qui, lorsqu'on actionne l'interrupteur à une position (18), émet de façon indépendante du réseau un signal d'émission de fréquence déterminée, auquel répond celui des interrupteurs de branche de ligne (24) dont le récepteur (27, 22, 23) est conçu pour cette fréquence, caractérisée en ce que chaque émetteur (21) émet comme signal d'émission une succession d'impulsions courtes indépendantes de l'information, avec des pauses d'impulsions fixées dont la durée est chaque fois affectée à une branche de ligne déterminée (3, 4, 5), en ce que dans chaque récepteur (27, 22, 23) est prévu un circuit (R4, C3) qui engendre une tension en dents de scie (fig. 5b) dont la période correspond aux pauses d'impulsions de la succession d'impulsions de réception (fig. 5a) et dont l'amplitude correspond par conséquent à la·durée des pauses d'impulsion, cette amplitude étant interprétée comme critère de manoeuvre pour l'interrupteur de branche de ligne considéré, au moyen d'un autre circuit (22, 23) du récepteur, et en ce que chaque interrupteur de branche de ligne (24) d'une branche de ligne (3, 4, 5) répond seulement à une succession d'impulsions de réception ayant la durée de pause d'impulsions affectée à cette branche de ligne (3, 4, 5) et qui correspond à la succession d'impulsions précisément émise.

2. Installation selon la revendication 1, caractérisée en ce que chaque émetteur (21) est réglable de telle sorte qu'il peut émettre des successions d'impulsions d'émission présentant au choix chacune des pauses d'impulsions auxquelles les différents récepteurs (27, 22, 23) manoeuvrent leurs interrupteurs de branche de ligne (24).

3. Installation selon l'une des revendications 1 ou 2, caractérisée en ce que chaque récepteur (27, 22, 23) est réglable de telle sorte que sur des successions d'impulsions de réception présentant chacune des pauses d'impulsions qu'émettent les émetteurs (21), il peut manoeuvrer son interrupteur de branche de ligne (24).

4. Installation selon l'une des revendications 2 ou 3, caractérisée en ce que chaque unité d'interrupteur (15, 16, 17) et/ou chaque bloc (11, 12, 13) présente une résistance variable (R3, R4) munie de positions d'arrêt.

5. Installation selon l'une des revendications précédentes, caractérisée en ce que chaque unité d'interrupteur à une position (15, 16, 17) présente une diode émettrice d'infrarouge (20, 20', D1) et que chaque bloc (11, 12, 13) présente une diode réceptrice d'infrarouge (14).

6. Installation selon l'une des revendications précédentes, dans laquelle l'unité d'interrupteur à une position présente un poussoir de grande surface, caractérisée en ce qu'au moyen du poussoir (18), on peut fermer un contact (K) du circuit émetteur (21) qui est relié par l'intermédiaire d'une résistance (R3) à la base d'un premier transistor (T1), en ce que le collecteur du premier transistor (T1) est relié à la base d'un transistor complémentaire (T2) dans le circuit de collecteur duquel se trouve la diode émettrice (20) et dont le collecteur est relié, par l'intermédiaire d'une branche de réaction (C1, R1), à la base du premier transistor (T1) et en ce que l'unité d'interrupteur à une position (15, 16, 17) présente, pour l'alimentation électrique, une batterie (B) et un condensateur (C1) relié en parallèle à celle-ci.

7. Installation selon l'une des revendications précédentes, caractérisée en ce que dans chaque bloc (11, 12, 13) est prévu un circuit de charge RC (R4, C3) pouvant être chargé par le réseau (R, Mp) par l'intermédiaire d'un étage redresseur (25) et dont le condensateur (C3) se décharge lorsqu'il apparaît une impulsion de réception, la tension en dents de scie apparaissant alors, étant filtrée dans un étage de filtrage (22) et interprétée par un discriminateur à fenêtre (23).

8. Installation selon l'une des revendications précédentes, caractérisée en ce que chaque impulsion d'émission de l'unité d'interrupteur à une position (15, 16, 17) est formée d'un paquet d'impulsions et dans le bloc (11, 12, 13) est prévu un filtre (C6, R12) qui est accordé sur la fréquence du paquet d'impulsions de l'unité d'interrupteur à une position adjointe.

9. Installation selon l'une des revendications précédentes, caractérisée en ce que le récepteur (27, 22, 23) et éventuellement un circuit de déclenchement (26) de l'interrupteur de branche de ligne (24) sont alimentés par le réseau (R, Mp) par l'intermédiaire d'un étage redresseur (25).

## Fig. 1

## Fig. 2

## Fig. 3

## Fig. 4

## Fig. 5

a)

b)

c)

d)

e)

Fig. 6

Fig. 7